# EUROPEAN PATENT APPLICATION

(11) **EP 1 109 227 A2**
(43) Date of publication of application: **20.06.2001**
(21) Application number: 00311259.6
(22) Date of filing: 15.12.2000
(51) Int. Cl.: H01L 29/92, H01L 21/02

(54) **Via capacitor**

(30) Priority: 17.12.1999 US 172439 P
(71) Applicant: Texas Instruments Incorporated, Dallas, Texas 75251 (US)
(72) Inventor: Haroun, Baher S., Allen, Texas 75002 (US); Evans, Brian L., Allen, Texas 75013 (US)
(74) Representative: Legg, Cyrus James Grahame

(57) **Abstract**

A capacitor includes a first conductive layer disposed outwardly from a semiconductor substrate and comprising a first plate and a second plate. The capacitor also includes a first via layer disposed outwardly from the first conductive layer and comprising a first via coupled to the first plate and a second via coupled to the second plate. The first and second vias are separated by a dielectric and are operable to be charged with different potentials to establish a capacitance between the first and second vias. The capacitor further includes a second conductive layer disposed outwardly from the first via layer and comprising a third plate coupled to the first via and a fourth plate coupled to the second via.

## Description

### TECHNICAL FIELD OF THE INVENTION

This invention relates generally to the field of electronic devices and, more particularly, to a via capacitor.

### BACKGROUND OF THE INVENTION

Capacitors are typical elements in integrated circuits. Decreasing the size of integrated circuits often leads to a corresponding decrease in the size of the capacitors used in those circuits. As the size of the capacitors decreases, difficulty may be encountered in maintaining a high capacitance, which often leads manufacturers to fabricate capacitors with higher densities in order to maintain a high capacitance. However, conventional high density capacitors typically require additional steps to fabricate, resulting in higher manufacturing costs.

In an effort to maintain capacitance levels without increasing fabrication costs, manufacturers of integrated circuits may use larger capacitors rather than smaller, high density capacitors. A disadvantage associated with this method is that the larger capacitors occupy physical space that could be used for other physical elements of the integrated circuits.

### SUMMARY OF THE INVENTION

The present invention recognizes a need for an improved via capacitor and a method for manufacturing a via capacitor that reduces or eliminates many shortcomings of prior systems and methods.

In accordance with one aspect of the present invention, a capacitor comprises a first conductive layer disposed outwardly from a semiconductor substrate and comprising a first plate and a second plate. The capacitor also comprises a first via layer disposed outwardly from the first conductive layer and comprising a first via coupled to the first plate and a second via coupled to the second plate. The first and second vias are separated by a dielectric and are each operable to be charged with different potentials to establish a capacitance between the first and second vias. The capacitor further comprises a second conductive layer disposed outwardly from the first via layer and comprising a third plate coupled to the first via and a fourth plate coupled to the second via.

Technical advantages of the present invention include the provision of a capacitive structure that uses inter-layer vias to contribute to the overall capacitance of the structure. While vias have been typically used to connect elements in an integrated circuit to a power supply, vias are not typically used in conventional capacitors and have never been used to actually contribute to the capacitance of the device. Conventional capacitors typically include two oppositely polarized conductive layers disposed one on top of the other and separated by a dielectric. Due to the typically opposite polarization of the two conductive layers, vias have not been used to connect the conductive layers because using a via to connect the layers would create a short circuit. One aspect of the present invention is the use of vias to couple stacked conductive layers and to provide a capacitance not only between adjacent plates in the conductive layers, but also between adjacent vias. This may be provided using a unique charging scheme.

The invention provides a higher density than other typical capacitors without the additional costs typically associated with fabricating high density capacitors. The invention, therefore, may reduce the costs of integrated circuits. In addition, multiple alternating layers of vias and conductive plates can be disposed one on top of the other, resulting in a stacked via capacitor and further increasing the density of the capacitor.

A further advantage of the via capacitor is the ability to fabricate the capacitors without adding additional steps to the fabrication process. The elimination of additional fabrication steps offers another cost reduction to manufacturers of integrated circuits.

In addition, the via capacitor can be designed to result in a structure more rigid than other typical capacitors. As mechanical stresses are applied to an integrated circuit, typical capacitors may become deformed, reducing the effectiveness of the capacitor. The via capacitor can be structured to resist mechanical stresses to a greater degree, increasing the performance of the capacitor.

Other technical advantages are readily apparent to one of skill in the art from the attached figures, description and claims.

### BRIEF DESCRIPTION OF THE DRAWINGS

For a more complete understanding of the present invention and the advantages thereof, reference is now made to the following descriptions taken in connection with the accompanying drawings, in which:
FIGURE 1 is a cross-sectional view of one exemplary embodiment of a via capacitor constructed in accordance with the teachings of the present invention;
FIGURE 2 is a cross-sectional view of another exemplary embodiment of a via capacitor constructed in accordance with the teachings of the present invention;
FIGURES 3a-3c are cut-away views of the via capacitor shown in FIGURE 2 along lines 3A-3C, respectively;
FIGURES 4a-4d illustrate an exemplary series of steps in the formation of a first conductive layer in a via capacitor;
FIGURES 5a-5d illustrate an exemplary series of steps in the formation of a via layer in a via capacitor; and
FIGURES 6a-6d illustrate an exemplary series of steps in the formation of a second conductive layer in a via capacitor.

### DETAILED DESCRIPTION OF THE INVENTION

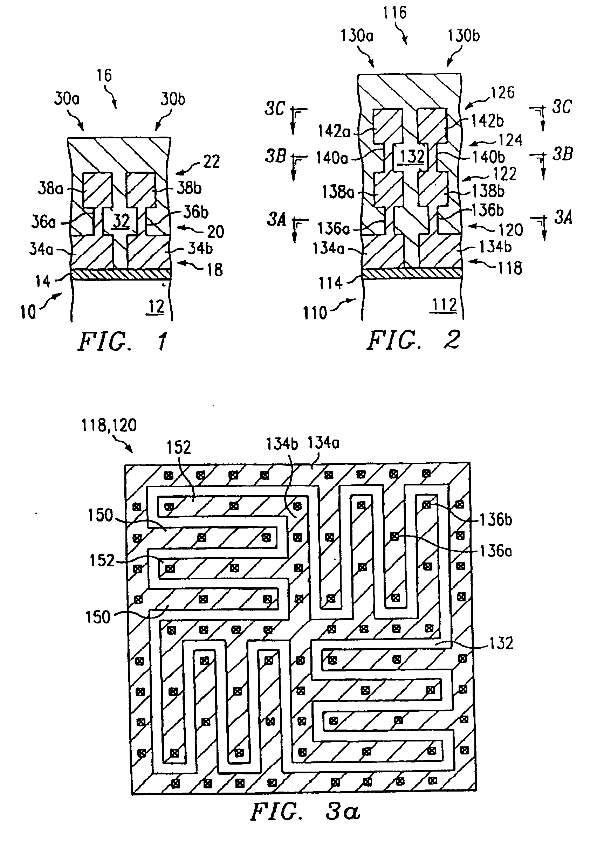

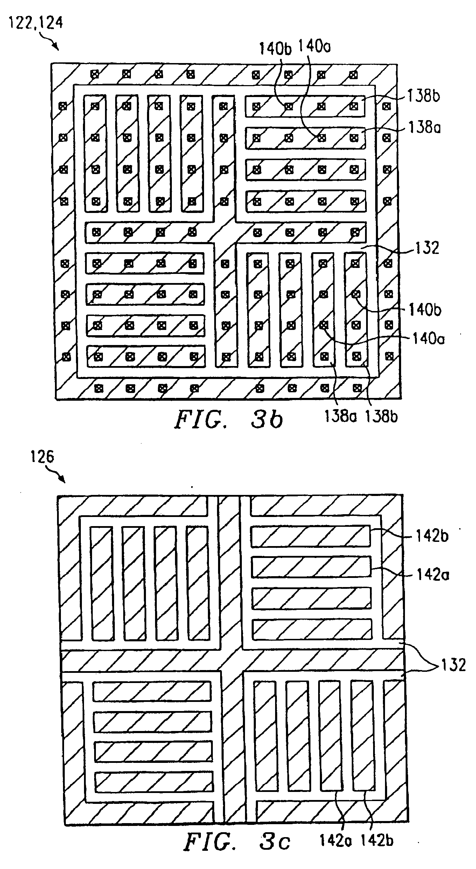

FIGURE 1 is a cross-sectional view of one exemplary embodiment of a via capacitor 16 constructed in accordance with the teachings of the present invention. In the illustrated embodiment, via capacitor 16 resides within an integrated circuit 10. In this example, integrated circuit 10 comprises a semiconductor substrate 12, intermediate layer 14 disposed outwardly from semiconductor substrate 12, and capacitor 16 disposed outwardly from intermediate layer 14. Intermediate layer 14 may comprise any layer, structure, or combination of layers and/or structures of integrated circuit 10 disposed inwardly from capacitor 16. In another embodiment, capacitor 16 may be in direct contact with semiconductor substrate 12 without any intermediate layers and/or structures 14 separating semiconductor substrate 12 and capacitor 16.

In the illustrated embodiment, capacitor 16 comprises alternating conductive layers and via layers. A first conductive layer 18 is disposed outwardly from semiconductor substrate 12, and a first via layer 20 is disposed outwardly from first conductive layer 18. A second conductive layer 22 is disposed outwardly from first via layer 20 and is coupled to first conductive layer 18 by first via layer 20. In this document, the term "couple" refers to any direct or indirect electrical connection between two or more elements. The elements said to be "coupled" to one another may or may not physically contact one another.

First conductive layer 18 is disposed outwardly from semiconductor substrate 12. In the illustrated embodiment, first conductive layer 18 comprises two or more conductive plates, each separated by a dielectric 32. In this document, the term "plate" may refer to any uniform or nonuniform structure capable of forming a lateral capacitance with an approximately adjacent structure. In this example, first conductive layer 18 is a feed layer, the plates of first conductive layer 18 comprising a first feed contact 34a and a second feed contact 34b disposed approximately adjacent to first feed contact 34a. Feed contacts 34a and 34b are separated by dielectric 32. Feed contacts 34 are coupled to a power supply (not explicitly shown), which allows feed contact 34a to be charged with one potential and feed contact 34b with a different potential. In one embodiment, feed contact 34a is operable to be charged with one potential, and feed contact 34b is operable to be charged with an approximately equal potential of opposite polarity.

Feed contacts 34 may be formed from any conductive material or combination of conductive materials including, for example, copper, aluminum, tungsten, and/or doped polysilicon. Dielectric 32 may comprise, for example, silicon dioxide, silicon nitride, silicon carbide, or any other suitable dielectric material or combination of dielectric materials. Dielectric 32 may comprise one or multiple layers without departing from the scope of the invention.

Although the illustrated embodiment shows first conductive layer 18 as the feed layer, the invention is not so limited. Any conductive layer could be coupled to the power supply and serve as a feed layer without departing from the scope of the invention. In addition, although the illustrated embodiment shows a single feed layer operable to couple both potentials to capacitor 16, integrated circuit 10 may include multiple feed layers, each coupling selected nodes 30 of capacitor 16 to a particular potential power supply.

First via layer 20 is disposed outwardly from first conductive layer 18. In the illustrated embodiment, first via layer 20 comprises two or more vias coupling first conductive layer 18 and second conductive layer 22. In this example, first via layer 20 comprises a first via 36a and a second via 36b. Vias 36 are separated by dielectric 32. Via 36a is coupled to feed contact 34a, and via 36b is coupled to feed contact 34b. Vias 36 may be formed from any conductive material or combination of conductive materials including, for example, copper, aluminum, tungsten, and/or doped polysilicon. Identification of vias in this document as a "first via," a "second via," a "third via," etc., is for identification purposes only and is not intended to limit the number of vias in any particular via layer or in capacitor 16.

Second conductive layer 22 is disposed outwardly from first via layer 20. In the illustrated embodiment, second conductive layer 22 comprises two or more conductive plates, each separated by dielectric 32. In this example, second conductive layer 22 comprises a first plate 38a and a second plate 38b disposed approximately adjacent to first plate 38a. Plates 38 are coupled to feed contacts 34 by via layer 20. Plate 38a is coupled to feed contact 34a by via 36a, and plate 38b is coupled to feed contact 34b by via 36b. Plates 38 may be formed from any conductive material or combination of conductive materials including, for example, copper, aluminum, tungsten, and/or doped polysilicon. Identification of plates in this document as a "first plate," a "second plate," a "third plate," etc., is for identification purposes only and is not intended to limit the number of plates in any particular conductive layer or in capacitor 16.

In the illustrated embodiment, capacitor 16 has two nodes 30a and 30b. Nodes 30a and 30b are separated by dielectric 32. In one aspect of operation, nodes 30a and 30b are operable to be charged with differing potentials, creating a capacitance between feed contacts 34, vias 36, and plates 38 of nodes 30a and 30b. In a particular embodiment, nodes 30a and 30b are operable to be charged with approximately equal magnitude, oppositely polarized charges.

Via 36a couples feed contact 34a and plate 38a, and via 36a and plate 38a are operable to be charged with approximately the same potential as feed contact 34a. Via 36b couples feed contact 34b and plate 38b, and via 36b and plate 38b are operable to be charged with approximately the same potential as feed contact 34b. Feed contact 34a has a different potential than feed contact 34b. The difference in potential, appropriate selection of dielectric 32 between nodes 30, and arrangement of nodes 30 create a lateral capacitance between feed contacts 34a and 34b in first conductive layer 18 and between plates 38a and 38b in second conductive layer 22. In addition, the arrangement and charging of vias 36 along with the presence of dielectric 32 creates an inter-via capacitance between vias 36a and 36b in first via layer 20. The inter-via capacitance advantageously contributes to the overall capacitance of capacitor 16.

Although the illustrated embodiment of capacitor 16 has only two nodes 30a and 30b, capacitor 16 may comprise any number of nodes 30, and each node 30 may comprise any number of conductive and via layers. In addition, although the illustrated embodiment shows a single via coupling each plate 34 to a plate 38, any number of vias could be used.

Capacitor 16 advantageously provides a high capacitance per unit of area. The use of vias 36 between conductive layers 18 and 22 creates an inter-via capacitance between vias 36 in via layer 20, in addition to the capacitance between plates 34 and 38 in conductive layers 18 and 22. The inter-via capacitance contributes to and increases the overall capacitance of capacitor 16. Also, capacitor 16 may be fabricated without additional steps to the fabrication process, reducing the costs of manufacturing capacitor 16. In addition, capacitor 16 has a structure that is more rigid than the structures of other typical capacitors. In the illustrated embodiment, vias 36 in via layer 20 provide support for plates 34 and 38 in conductive layers 18 and 22. This support may reduce the amount of deformation of plates 34 and 38 and allow capacitor 16 to resist mechanical stresses to a greater degree.

FIGURE 2 is a cross-sectional view of another exemplary embodiment of a via capacitor 116 constructed in accordance with the teachings of the present invention. Capacitor 116 comprises a first conductive layer 118, a first via layer 120, a second conductive layer 122, a second via layer 124, and a third conductive layer 126.

First conductive layer 118 is disposed outwardly from a semiconductor substrate 112 and comprises a first feed contact 134a and a second feed contact 134b. First conductive layer 118 may be disposed on one or multiple intermediate layers and/or structures 114 or directly on semiconductor substrate 112. First via layer 120 is disposed outwardly from first conductive layer 118 and comprises vias 136a and 136b, and second conductive layer 122 is disposed outwardly from first via layer 120 and comprises plates 138a and 138b. First conductive layer 118, first via layer 120, and second conductive layer 122 may be the same as or similar to first conductive layer 18, first via layer 20, and second conductive layer 22, respectively, from FIGURE 1.

In the illustrated embodiment, second via layer 124 is disposed outwardly from second conductive layer 122 and comprises two or more vias. In this embodiment, third conductive layer 126 is disposed outwardly from second via layer 124 and comprises two or more conductive plates. In this example, second via layer 124 comprises two vias 140a and 140b, and third conductive layer 126 comprises two plates 142a and 142b. A dielectric 132 separates each plate 142 from one another and each via 140 from one another.

Via 140a couples plates 138a and 142a, and via 140b couples plates 138b and 142b. Via 140a and plate 142a are operable to be charged with approximately the same potential as feed contact 134a, and via 140b and plate 142b are operable to be charged with approximately the same potential as feed contact 134b. The structural arrangement of the conductive plates, vias, and dielectric, as well as the difference in potential, creates a capacitance between plates 142a and 142b and an inter-via capacitance between vias 140a and 140b.

Plates 142 and vias 140 may be formed from any conductive material or combination of conductive materials including, for example, copper, aluminum, tungsten, and/or doped polysilicon. Dielectric 132 may comprise, for example, silicon dioxide, silicon nitride, silicon carbide, or any other suitable dielectric material or materials comprising one or multiple layers.

Capacitor 116 may further comprise any number of alternating via and conductive layers. Each plate in each conductive layer in capacitor 116 is coupled to a plate in another conductive layer by at least one via. The vias are arranged and charged so that each via having one potential is approximately adjacent to at least one other via having a different potential, creating an inter-via capacitance between the vias in each via layer.

Although the illustrated embodiment shows feed contacts 134 in first conductive layer 118, those skilled in the art will recognize that feed contacts 134a and 134b may be fabricated anywhere in capacitor 116. Feed contacts 134a and 134b may be located in third conductive layer 126 or in any other conductive layer. Feed contacts 134a and 134b could also be located on different conductive layers within capacitor 116. For example, feed contact 134a may be fabricated on first conductive layer 118, and feed contact 134b may be fabricated on third conductive layer 126. In addition, multiple feed contacts may feed each node 130.

FIGURES 3a-3c are cut-away views of via capacitor 116 shown in FIGURE 2 along lines 3A-3C, respectively. FIGURE 3a is a cut-away view of capacitor 116 along line 3A illustrated in FIGURE 2, showing first conductive layer 118 and first via layer 120. In the illustrated embodiment, fist conductive layer 118 is a feed layer comprising first feed contact 134a and second feed contact 134b. In this embodiment, first feed contact 134a comprises a plurality of first feed fingers 150, and second feed contact 134b comprises a plurality of second feed fingers 152. First feed fingers 150 and second feed fingers 152 are separated by dielectric 132. In this example, first feed fingers 150 and second feed fingers 152 are interlaced such that each first feed finger 150 is approximately adjacent to at least one second feed finger 152.

In the illustrated embodiment, first via layer 120 comprises a plurality of vias 136a coupled to feed contact 134a and a plurality of vias 136b coupled to feed contact 134b. Vias 136 are separated by dielectric 132. Vias 136a are operable to be charged with approximately the same potential as feed contact 134a, and vias 136b are operable to be charged with approximately the same potential as feed contact 134b. Vias 136 are arranged and charged so that each via 136a is approximately adjacent to at least one via 136b. The difference in potential and dielectric 132 between vias 136a and 136b creates a capacitance between vias 136a and 136b.

FIGURE 3b is a cut-away view of capacitor 116 along line 3B illustrated in FIGURE 2, showing second conductive layer 122 and second via layer 124. In the illustrated embodiment, second conductive layer 122 comprises a plurality of plates 138a coupled to feed contact 134a and a plurality of plates 138b coupled to feed contact 134b. Dielectric 132 separates plates 138 from one another. Each plate 138 is coupled to first conductive layer 118 by the vias 136 illustrated in FIGURE 3a. Vias 136a couple plates 138a to feed contact 134a, and plates 138a are operable to be charged with approximately the same potential as feed contact 134a. Vias 136b couple plates 138b to feed contact 134b, and plates 138b are operable to be charged with approximately the same potential as feed contact 134b. The difference in potential and presence of dielectric 132 creates a capacitance between plates 138a and 138b.

In the illustrated embodiment, second via layer 124 comprises a plurality of vias 140a coupling plates 138a to third conductive layer 126 and a plurality of vias 140b coupling plates 138b to third conductive layer 126. Vias 140 are separated by dielectric 132. Vias 140a are operable to be charged with approximately the same potential as plates 138a, which have approximately the same potential as feed contact 134a. Vias 140b are operable to be charged with approximately the same potential as plates 138b, which have approximately the same potential as feed contact 134b. Vias 140 are arranged and charged so that each via 140a is approximately adjacent to at least one via 140b, and the difference in potential and presence of dielectric 132 creates a capacitance between vias 140a and 140b.

FIGURE 3c is a cut-away view of capacitor 116 along line 3C illustrated in FIGURE 2, showing third conductive layer 126. In the illustrated embodiment, third conductive layer 126 comprises a plurality of plates 142a coupled to plates 138a and a plurality of plates 142b coupled to plates 138b. Dielectric 132 separates plates 142 from one another. Each plate 142 is coupled to second conductive layer 122 by the vias 140 illustrated in FIGURE 3b. Vias 140a couple plates 142a to plates 138a, and plates 142a are operable to be charged with approximately the same potential as feed contact 134a. Vias 140b couple plates 142b to plates 138b, and plates 142b are operable to be charged with approximately the same potential as feed contact 134b. The difference in potential and presence of dielectric 132 creates a capacitance between plates 142a and 142b.

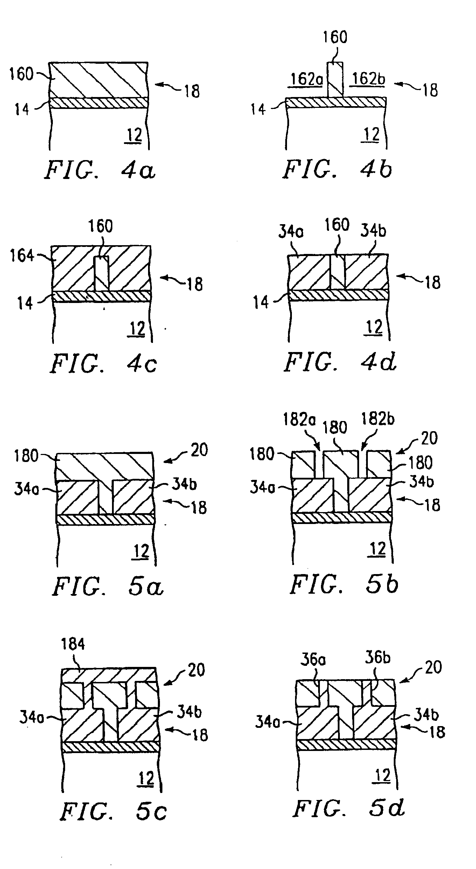

FIGURES 4a-4d illustrate an exemplary series of steps in the formation of a first conductive layer 18 of a via capacitor such as via capacitor 16 shown in FIGURE 1. In FIGURE 4a, a dielectric material 160 is formed outwardly from semiconductor substrate 12. Dielectric material 160 may be formed directly on semiconductor substrate 12 or on one or more intermediate layers and/or structures 14. Dielectric material 160 may comprise any suitable dielectric material or materials comprising one or multiple layers. In FIGURE 4b, cavities 162a and 162b are formed in dielectric material 160 using any appropriate fabrication process, such as a pattern and etch. Cavities 162 may be formed to approximately conform to the shape of feed contacts 34. In FIGURE 4c, a conductive material 164 is formed outwardly from and in cavities 162. Conductive material 164 may comprise any conductive material or combination of conductive materials. In FIGURE 4d, dielectric material 160 and conductive material 164 are polished to form feed contacts 34a and 34b separated by dielectric 160.

Although the illustrated steps show dielectric material 160 being formed before conductive material 164, the invention is not so limited. The series of steps illustrated in FIGURES 4a-4d show one particular example of a method of forming feed contacts 34a and 34b in first conductive layer 18. These structures could alternatively be formed using a wide variety of methods. For example, conductive material 164 could initially be formed outwardly from semiconductor substrate 12 or intermediate layer 14 and formed into feed contacts 34 using any appropriate fabrication process, such as a pattern and etch. Dielectric material 160 can then be formed outwardly from and between feed contacts 34a and 34b.

In addition, although the illustrated embodiment shows the formation of feed contacts 34a and 34b in first conductive layer 18, similar steps could be used to form plates 38 in first conductive layer 18.

FIGURES 5a-5d illustrate an exemplary series of steps in the formation of a via layer of a via capacitor such as via capacitor 16 shown in FIGURE 1. In FIGURE 5a, a dielectric material 180 is formed outwardly from first conductive layer 18. Dielectric material 180 may comprise any suitable dielectric material or materials comprising one or multiple layers, and dielectric material 180 may be the same as or different than dielectric material 160. In FIGURE 5b, cavities 182a and 182b are formed in dielectric material 180 using any appropriate fabrication process, such as a pattern and etch. Cavities 182 may be formed to approximately conform to the shape of vias 36. In FIGURE 5c, a conductive material 184 is formed outwardly from and in cavities 182. Conductive material 184 may comprise any conductive material or combination of conductive materials, and conductive material 184 need not be the same as conductive material 164. In FIGURE 5d, dielectric material 180 and conductive material 184 are polished to form vias 36a and 36b separated by dielectric 180.

Although the illustrated steps show dielectric material 180 being formed before conductive material 184, the invention is not so limited. The series of steps illustrated in FIGURES 5a-5d show one particular method of forming vias 36a and 36b. These structures could alternately be formed using a wide variety of methods. For example, conductive material 184 could initially be formed outwardly from first conductive layer 18 and, using any appropriate fabrication process, formed into vias 36a and 36b. Dielectric material 180 can then be formed outwardly from and between vias 36a and 36b.

In addition, although FIGURES 4a-4d and FIGURES 5a-5d illustrate the formation of first conductive layer 18 and first via layer 20 as two independent series of steps, first conductive layer 18 and first via layer 20 could be formed using an integrated series of steps. For example, conductive material 164 could be formed outwardly from semiconductor substrate 12 and formed into feed contacts 34. Dielectric material 160 can be formed between feed contacts 34 in first conductive layer 18 and outwardly in first via layer 20. Cavities 182 could then be formed in dielectric material 160, and conductive material 184 could be formed outwardly from and in cavities 182. Conductive material 184 and dielectric material 160 could be polished to form vias 36 coupled to feed contacts 34.

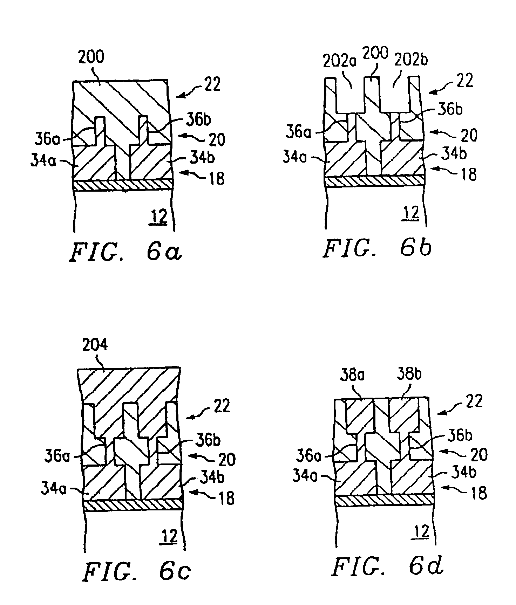

FIGURES 6a-6d illustrate an exemplary series of steps in the formation of a second conductive layer 22 of a via capacitor such as via capacitor 16 shown in FIGURE 1. In FIGURE 6a, a dielectric material 200 is formed outwardly from first via layer 20. Dielectric material 200 may comprise any suitable dielectric material or materials comprising one or multiple layers, and dielectric material 200 need not be the same as dielectric material 160 or 180. In FIGURE 6b, cavities 202a and 202b are formed in dielectric material 200 using any appropriate fabrication process, such as a pattern and etch. Cavities 202 may be formed to approximately conform to the shape of plates 38. In FIGURE 6c, a conductive material 204 is formed outwardly from and in cavities 202. Conductive material 204 may comprise any conductive material or combination of conductive materials, and conductive material 204 may be the same as or different than conductive material 164 or 184. In FIGURE 6d, dielectric material 200 and conductive material 204 are polished to form plates 38a and 38b separated by dielectric 200.

Although the illustrated steps show dielectric material 200 being formed before conductive material 204, other methods, including the method described above for first conductive layer 18, may be used. Also, although FIGURES 5a-5d and FIGURES 6a-6d illustrate the formation of first via layer 20 and second conductive layer 22 as two independent series of steps, first via layer 20 and second conductive layer 22 could be formed using an integrated series of steps. For example, conductive material 164 can be formed outwardly from semiconductor substrate 12 and formed into feed contacts 34. Dielectric material 160 can be formed between feed contacts 34 in first conductive layer 18 and outwardly in first via layer 20 and second conductive layer 22. Cavities 202 can be formed in dielectric material 160, and then cavities 182 can be formed in dielectric material 160. Conductive material 204 can be formed outwardly from and in cavities 182 and 202. Conductive material 204 and dielectric material 164 can be polished to form vias 36 and plates 38.

In addition, although FIGURES 6a-6d have been described as forming plates 38 in second conductive layer 22, similar steps could be implemented to form feed contacts 34 in second conductive layer 22.

Although the present invention has been described in several embodiments, a myriad of changes, variations, alterations, transformations, and modifications may be suggested to one skilled in the art, and it is intended that the present invention encompass such changes, variations, alterations, transformations, and modifications.

## Claims

1. A capacitor comprising:
a first conductive layer disposed outwardly from a semiconductor substrate and comprising a first plate and a second plate;
a first via layer disposed outwardly from the first conductive layer and comprising a first via coupled to the first plate and a second via coupled to the second plate, the first and second vias separated by a dielectric and each operable to be charged with different potentials to establish a capacitance between the first and second vias; and
a second conductive layer disposed outwardly from the first via layer and comprising a third plate coupled to the first via and a fourth plate coupled to the second via.

2. A capacitor as claimed in claim 1, further comprising:
a second via layer disposed outwardly from the second conductive layer and comprising a third via coupled to the third plate and a fourth via coupled to the fourth plate, the third and fourth vias separated by a dielectric and each operable to be charged with different potentials to establish a capacitance between the third and fourth vias; and
a third conductive layer disposed outwardly from the second via layer and comprising a fifth plate coupled to the third via and a sixth plate coupled to the fourth via.

3. A capacitor as claimed in claim 1 or claim 2, wherein the first conductive layer comprises a first feed contact and a second feed contact, the first feed contact coupled to the first via and operable to receive a first potential, the second feed contact coupled to the second via and operable to receive a second potential different than the first potential.

4. A capacitor as claimed in claim 1 or claim 2, wherein the second conductive layer comprises a first feed contact and a second feed contact, the first feed contact coupled to the first via and operable to receive a first potential, the second feed contact coupled to the second via and operable to receive a second potential different than the first potential.

5. A capacitor as claimed in claim 2, wherein the third conductive layer comprises a first feed contact and a second feed contact, the first feed contact coupled to the third via and operable to receive a first potential, the second feed contact coupled to the fourth via and operable to receive a second potential different than the first potential.

6. A capacitor as claimed in claim 2, wherein one of the conductive layers comprises a first feed contact operable to receive a first potential and another of the conductive layers comprises a second feed contact operable to receive a second potential different than the first potential, the first feed contact operable to charge the first and third vias, the second feed contact operable to charge the second and fourth vias.

7. A capacitor as claimed in claim 1 or claim 2, wherein one of the conductive layers comprises a first feed contact operable to receive a first potential and one of the conductive layers comprises a second feed contact operable to receive a second potential, the first feed contact operable to charge the first via and any via coupled thereto, the second feed contact operable to charge the second via and any via coupled thereto.

8. A capacitor as claimed in any preceding claim, wherein each via comprises a material selected from the group consisting of tungsten, copper, aluminum, and doped polysilicon.

9. An integrated circuit comprising a capacitor as claimed in any preceding claim.

10. A method of forming a capacitor comprising:
forming a first conductive layer disposed outwardly from a semiconductor substrate and comprising a first plate and a second plate;
forming a first via layer disposed outwardly from the first conductive layer and comprising a first via coupled to the first plate and a second via coupled to the second plate, the first and second vias separated by a dielectric and each operable to be charged with different potentials to establish a capacitance between the first and second vias; and
forming a second conductive layer disposed outwardly from the first via layer and comprising a third plate coupled to the first via and a fourth plate coupled to the second via.

11. A method as claimed in claim 10, further comprising:
forming a second via layer disposed outwardly from the second conductive layer and comprising a third via coupled to the third plate and a fourth via coupled to the fourth plate, the third and fourth vias separated by a dielectric and each operable to be charged with different potentials to establish a capacitance between the third and fourth vias; and
forming a third conductive layer disposed outwardly from the second via layer and comprising a fifth plate coupled to the third via and a sixth plate coupled to the fourth via.

12. A method as claimed in claim 10 or claim 11, wherein forming the first conductive layer comprises forming a first feed contact and a second feed contact, the first feed contact coupled to the first via and operable to receive a first potential, the second feed contact coupled to the second via and operable to receive a second potential different than the first potential.

13. A method as claimed in claim 10 or claim 11, wherein forming the second conductive layer comprises forming a first feed contact and a second feed contact, the first feed contact coupled to the first via and operable to receive a first potential, the second feed contact coupled to the second via and operable to receive a second potential different than the first potential.

14. A method as claimed in claim 11, wherein forming the third conductive layer comprises forming a first feed contact operable to receive a first potential and a second feed contact operable to receive a second potential different than the first potential, the first feed contact operable to charge the first and third vias, the second feed contact operable to charge the second and fourth vias.

15. A method as claimed in claim 10 or claim 11, wherein forming one of the conductive layers comprises forming a first feed contact operable to receive a first potential and forming one of the conductive layers comprises forming a second feed contact operable to receive a second potential, the first feed contact operable to charge the first via and any via coupled thereto, the second feed contact operable to charge the second via and any via coupled thereto.

16. A method as claimed in any one of claims 10 to 15, wherein each via comprises a material selected from the group consisting of tungsten, copper, aluminum, and doped polysilicon.
